# FASCICULE DE BREVET EUROPEEN

(11) **EP 0 869 594 B1**
(45) Date de publication et mention de la délivrance du brevet: **04.08.2004**
(21) Numéro de dépôt: 98400737.7
(22) Date de dépôt: 30.03.1998
(51) Int. Cl.: H02B 1/04

(54) **Ensemble de départ-moteur**
Motoransteuerbaugruppe
Motor starter block

(30) Priorité: 01.04.1997 FR 9704042
(43) Date de publication de la demande: 07.10.1998
(73) Titulaire: Schneider Electric Industries SAS, 92500 Rueil-Malmaison (FR)
(72) Inventeur: Girard, Michel, 21910 Corcelles-Les-Citeaux (FR); Latour, Emmanuel, 21240 Talant (FR); Sibille, Didier, 21000 Dijon (FR)

(56) Documents cités:
- EP-A- 0 407 241
- EP-A- 0 425 393
- EP-A- 0 588 712
- DE-A- 1 944 236
- DE-U- 29 507 456

## Description

La présente invention concerne un ensemble d'appareils électriques affectés à la commande de puissance de charges, notamment d'appareils de départ-moteur, cet ensemble comprenant un socle et un jeu de conducteurs de puissance prévu pour l'alimentation des charges, pour chaque charge une paire d'appareils montée sur le socle et composée d'un disjoncteur et d'un contacteur, les paires d'appareils étant juxtaposables sur le socle.

Un tel ensemble d'appareils sert à alimenter une charge telle qu'un moteur, pour le mettre en marche ou à l'arrêt en fonction de la mise sous tension ou hors tension de conducteurs de contrôle du contacteur; le disjoncteur est adjoint au contacteur pour couper les lignes d'alimentation du contacteur lorsqu'il constate au moyen d'organes de surveillance appropriés une anomalie de fonctionnement, par exemple une surintensité, dans l'une au moins de ces lignes.

Les ensembles de départ-moteur connus comprennent des socles ou embases munis d'un tronçon de profilé porteur du disjoncteur et d'un tronçon de profilé porteur du contacteur ; l'opérateur doit câbler le contacteur avec le disjoncteur, relier celui-ci au jeu de barres et câbler les conducteurs de contrôle aux bornes correspondantes du contacteur et éventuellement à un additif de signalisation qui est adjoint au disjoncteur et qui ouvre le circuit de contrôle en cas de déclenchement du disjoncteur. Les opérations de câblage et de montage que ceci implique sont longues et fastidieuses. Il est d'autre part souhaitable de pouvoir regrouper plusieurs ensembles contacteur-disjoncteur en un même dispositif, notamment lorsque ces ensembles doivent être raccordés à un bus de commande.

Le document EP-A 0 588 712 décrit une pièce d'association d'un contacteur avec un disjoncteur. Une telle pièce permet d'accrocher le contacteur au disjoncteur et d'assurer leur interconnexion de puissance, mais n'évite pas la nécessité d'un rail porteur pour le disjoncteur et n'assure pas d'interconnexion de contrôle. L'invention a pour but de simplifier les opérations de montage et de démontage de plusieurs paires d'appareils du genre disjoncteur-contacteur et de réduire les opérations de câblage de ces appareils, tout en facilitant leur raccordement à des conducteurs de contrôle, par exemple à un bus de contrôle. Le terme "contrôle" est pris ici au sens large et désigne aussi bien la commande des appareils de l'ensemble que la signalisation d'état de ces appareils ou la commande d'autres appareils en fonction de leur état.

Selon l'invention, le socle comporte d'une part une aire de support pour recevoir plusieurs paires d'appareils et d'autre part des broches de puissance et de contrôle coopérant avec des bornes respectives de puissance et de contrôle des paires d'appareils, et l'un des appareils est engagé sur les broches de connexion de puissance et de contrôle du socle selon une direction d'engagement qui est sensiblement parallèle à l'aire de support.

De préférence, les paires d'appareils sont montées de façon unitaire sur le socle selon la direction précitée, au moyen d'au moins un bloc associé muni d'un organe d'emboîtement coopérant avec un logement doté de butées ou d'épaulements de retenue et prévu sur ou dans le socle.

Le socle peut comporter une console s'étendant à partir de l'aire de support en avancée dans une direction perpendiculaire à l'aire pour loger le jeu de conducteurs de puissance et présentant des éléments de connexion à enfichage pour coopérer avec le disjoncteur, ou un additif de signalisation adjoint au disjoncteur, de chaque paire d'appareils ; le socle peut aussi loger derrière l'aire de pose un circuit imprimé muni, pour chaque paire d'appareils, de pistes d'interconnexion de la bobine du contacteur avec un bus de commande et de connecteurs correspondants.

Il est avantageux que le contacteur soit associé au disjoncteur au moyen d'un bloc intermédiaire d'interconnexion de puissance qui est doté d'un organe d'emboîtement coopérant avec un organe d'emboîtement correspondant prévu sur ou dans le socle et qui comprend d'une part des broches d'interconnexion de puissance entre contacteur et disjoncteur, d'autre part des éléments d'enfichage coopérant avec des éléments de connexion complémentaires prévus sur le socle. D'autre part, un bloc terminal peut être fixé sous le contacteur, ce bloc terminal étant doté d'un organe d'emboîtement qui coopère avec un organe d'emboîtement correspondant prévu sur ou dans le socle et comprenant des broches d'interconnexion avec des bornes de contrôle du contacteur. Les organes d'emboîtement du socle sont de préférence des logements ménagés dans l'aire de support du socle pour procurer des éléments de guidage, de maintien et de butée aux paires d'appareils. Un organe d'immobilisation peut être rapporté au bloc intermédiaire ou terminal associé à la paire d'appareils pour empêcher celle-ci de se déplacer à l'opposé de sa direction d'engagement.

La description va être faite ci-après d'un mode de réalisation de l'invention, à titre d'exemple et en regard des dessins annexés.

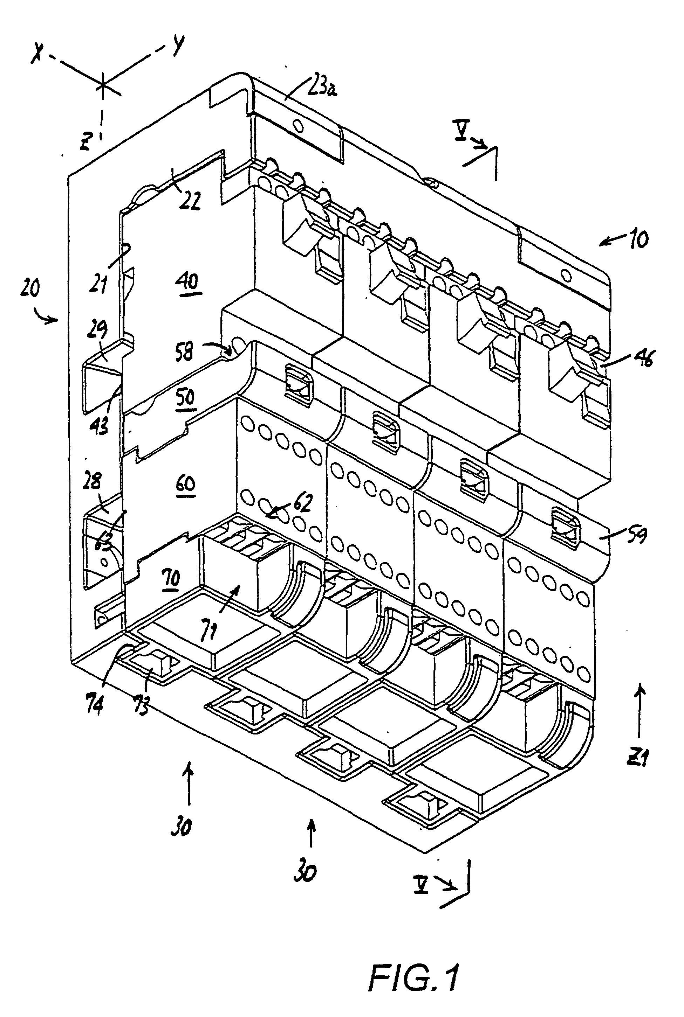

La figure 1 représente en perspective un ensemble de départ-moteur conforme à l'invention.

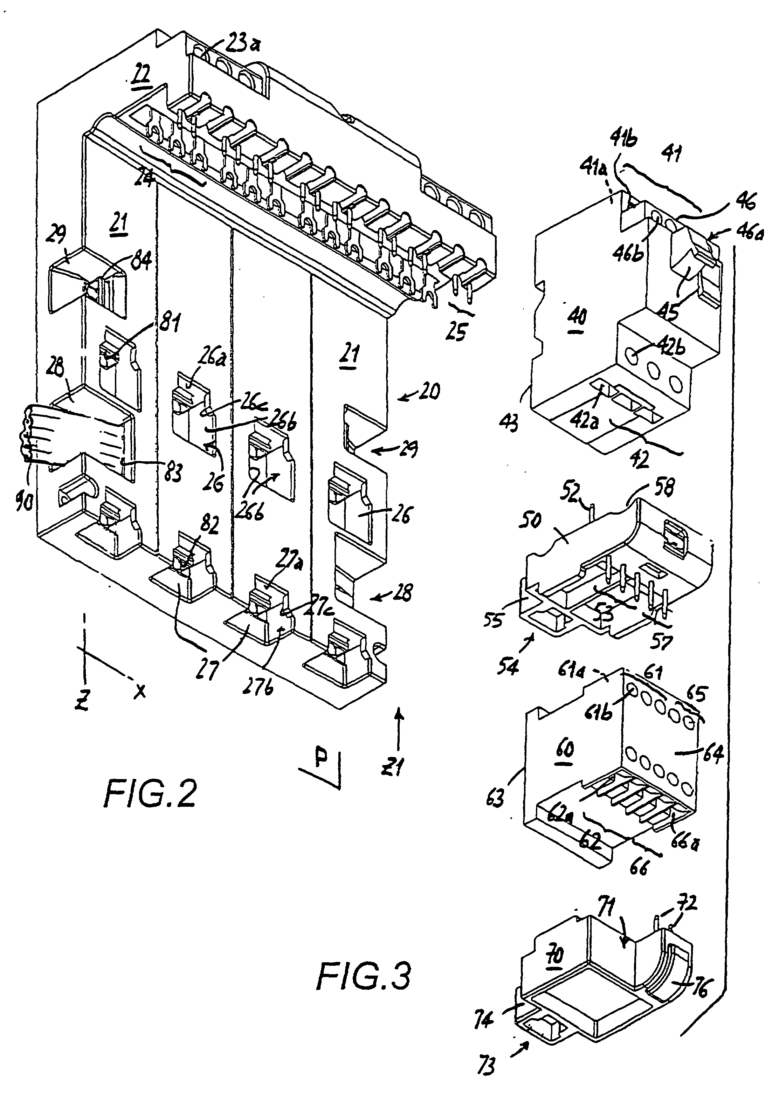

La figure 2 représente en perspective le même ensemble débarrassé des éléments contacteur-disjoncteur.
La figure 3 montre par une vue en perspective éclatée un tel élément.

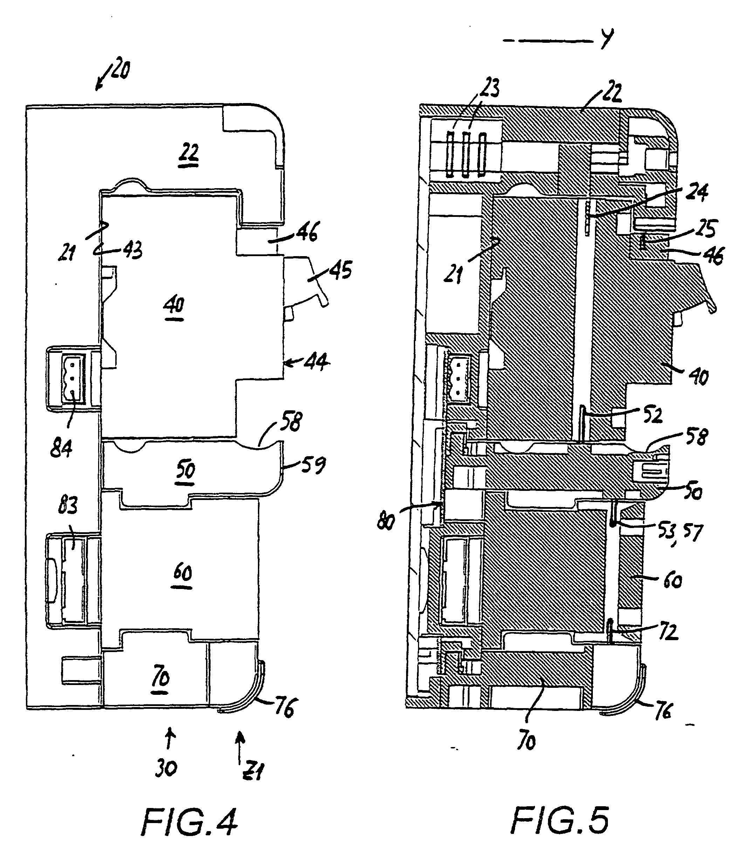

Les figures 4 et 5 montrent l'ensemble de la figure 1, respectivement en vue de côté et en coupe selon V-V.
La figure 6 montre en perspective le circuit imprimé du socle.
Les figures 7 et 8 montrent en perspective de dessus des détails du, bloc intermédiaire et du bloc terminal.
La figure 9 montre en perspective de dessous une variante de réalisation du socle.
La figure 10 représente en vue éclatée la console d'une variante de socle à deux éléments.

Le dispositif représenté est un ensemble de départ-moteur à quatre éléments, mais il va de soi qu'il peut comprendre un nombre d'éléments de départ différent, par exemple un, deux ou huit. De même, le dispositif peut être assemblé et connecté par tous moyens usuels à un dispositif voisin.

L'ensemble de départ-moteur 10 comprend un socle 20 sur lequel sont emboîtés et connectés des sous-ensembles de départ 30. Chaque sous-ensemble comprend une paire d'appareils électriques et deux blocs de connexion associés, à savoir un disjoncteur 40, un bloc intermédiaire 50, un contacteur 60 et un bloc terminal 70. Le socle 20 peut être fixé à l'arrière à un support par des moyens de fixation usuels : éléments d'encliquetage, vis, etc..

Le socle 20 comprend un corps de faible profondeur doté d'une aire frontale de support 21 généralement parallèle à un plan P pour porter les sous-ensembles 30 et assurer les interconnexions entre leurs composants et, en saillie à partir du corps selon une direction Y perpendiculaire au plan P, une avancée supérieure 22 en forme de console ; le socle loge un jeu de conducteurs d'alimentation 23 par exemple des barres, qui s'étendent selon une direction générale X parallèle à P et sont reliées d'une part à un raccordement d'alimentation 23a latéral ou, comme représenté, frontal et d'autre part à des broches de connexion de puissance 24 ; la console 22 présente aussi des broches de connexion de contrôle 25; les broches 24 et 25 s'étendent selon une direction Z parallèle à P et perpendiculaire à X et Y. Le socle 20 loge un circuit imprimé 80 qui est parallèle à P et assure les interconnexions de contrôle de via des connecteurs 81,82 et la connexion externe de contrôle via des connecteurs latéraux 83 ; le circuit imprimé 80 sera décrit plus loin.

Le boîtier du disjoncteur 40 présente des bornes amont 41 et aval 42, accessibles pour le raccordement de conducteurs souples ou rigides par des orifices respectifs 41a et 42a et à des outils de manoeuvre par des orifices frontaux 41b,42b. Le disjoncteur 40 présente une face arrière 43 et, en saillie vers l'avant, un nez 44, muni d'au moins un bouton de commande manuelle d'ouverture/fermeture 44a. Sur le nez 44 du disjoncteur est disposé un additif de signalisation 45 doté de bornes 46 ; les bornes 46 comprennent des accès supérieurs 46a pour la connexion des broches 26 et des orifices frontaux 46b pour la manoeuvre de ces bornes.

Le boîtier du contacteur 60 présente des bornes de puissance amont 61 et aval 62, accessibles pour le raccordement de conducteurs souple ou rigides par des orifices supérieurs 61a et inférieurs 62a et à des outils de manoeuvre, sur une face avant 64, par des orifices frontaux 61b,62b ; le boîtier du contacteur 60 offre aussi une face arrière 63 et, à côté des bornes de puissance amont 61 et aval 62, des bornes de contrôle amont 65 et aval 66 avec onfices d'accès respectifs 65a,66a. Selon les cas, la bobine du contacteur est raccordée à deux bornes de contrôle amont ou à une borne de contrôle amont et à une borne de contrôle aval.

Le bloc intermédiaire 50 est de faible hauteur et comprend des conducteurs 51 d'interconnexion de puissance entre disjoncteur et contacteur, se terminant à cet effet par des broches 52 pour coopérer avec les bornes aval 42 du disjoncteur 40 et par des broches 53 pour coopérer avec les bornes amont 61 du contacteur 60. Le bloc intermédiaire 50 comporte en outre à l'arrière un talon d'emboîtement et de connexion 54 ; ce talon est muni d'une part de formes 55 emboîtables dans un logement 26 du socle pour coopérer avec une face de butée haute 26a, des faces de butée latérales 26b et des épaulements 26c de retenue vers l'avant ; le talon 54 est d'autre part muni d'éléments de connexion de contrôle 56 dirigés selon Z et coopérant avec le connecteur 81 disposé sur le circuit imprimé et accessible au fond du logement 26. Des broches inférieures de contrôle 57 adjacentes aux broches de puissance 53 sont disposées pour se connecter aux bornes de contrôle amont 65 du contacteur 60.

Il convient d'observer que le bloc intermédiaire 50 présente à sa partie supérieure des formes 58 adaptées à la préhension par un doigt de l'opérateur pour faciliter le déplacement du sous-ensemble selon Z pour son montage et son démontage.

Le bloc terminal 70 ménage par un évidement 71 un passage pour des conducteurs de puissance destinés à connecter les bornes aval 62 du contacteur 60 à la charge ; le bloc 70 comprend des broches de contrôle 72 à connecter aux bornes aval de contrôle 66 du contacteur et un talon 73 d'emboîtement et de connexion. Ce talon est muni d'une part de formes d'emboîtement 74 pour coopérer avec des formes et parois d'un logement 27 du socle, en particulier avec une butée haute 27a, des butées latérales 27b et des épaulements de retenue avant 27c. Le talon 73 est d'autre part muni d'éléments de connexion de contrôle 75 dirigés selon Z et coopérant avec un connecteur 82 prévu au fond du logement 27. Un verrou 76 commandant des éléments d'encliquetage du bloc 70 dans le logement 27 peut d'autre part être prévu à l'avant du bloc 70 pour confirmer l'immobilisation du sous-ensemble sur le socle.

Le socle 20 comprend, outre les logements 26,27 et les connecteurs associés 81,82, des logements latéraux 28 comprenant des connecteurs 83 pour assurer le raccordement de connecteurs auxquels sont reliés des conducteurs de contrôle et/ou commande 90 qui assurent la liaison avec un automate programmable ou font partie d'un bus de terrain. Des logements latéraux supplémentaires 29 comprenant des connecteurs 84 sont prévus pour le raccordement de conducteurs d'alimentation à connecter à des relais prévus sur le circuit imprimé 80 lorsqu'une amplification de tension est souhaitée.

On notera que l'aire de support 21 est sensiblement plane, à l'exception des parties en retrait que constituent les logements 26-29, de sorte que les sous-ensembles 30 peuvent être, après introduction sensiblement selon Y des talons 54,73 des blocs intermédiaire 50 et terminal 70, engagés et connectés selon la direction Z parallèlement au plan P de l'aire 21, et cela sans nécessiter de câblage. Les faces arrière 43,63 du disjoncteur et du contacteur sont coplanaires avec les faces arrière des blocs 50,70. La face avant 59 du bloc 50 est en saillie sous le nez 44 pour faciliter la préhension des formes 58.

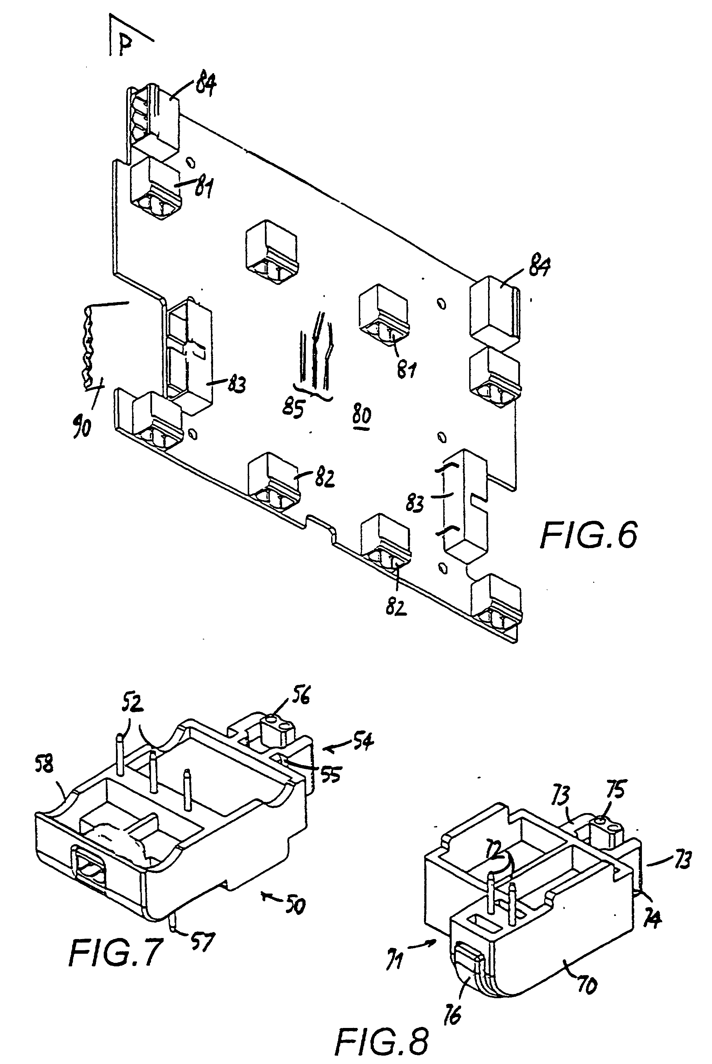

Le circuit imprimé 80 est illustré à part sur la figure 6 pour mieux montrer ses connecteurs 81-84. le circuit 80 assure à l'aide de pistes 85 les interconnexions souhaitées.

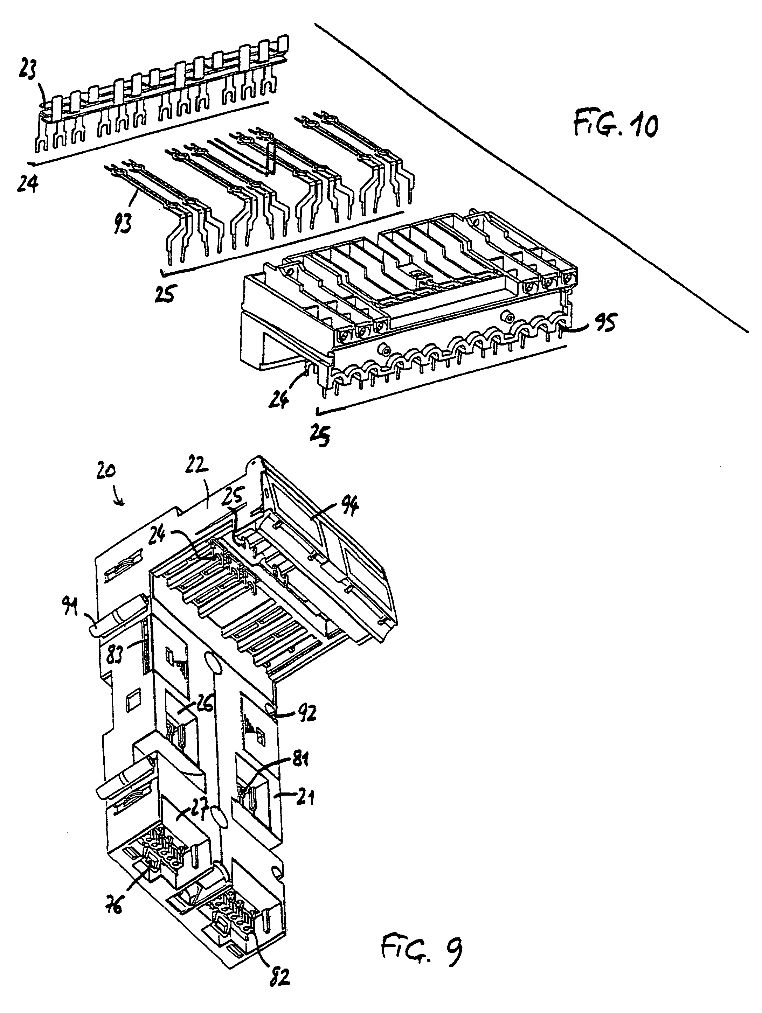

Le socle 20 illustré sur la figure 9 comprend d'un côté des éléments latéraux en relief 91 et de l'autre côté des éléments en creux complémentaires 92, afin de contribuer à l'assemblage de socles voisins. On voit sur la figure 9 une variante de verrou élastique 76 prévu pour bloquer le bloc inférieur 70 ; l'actionnement du verrou s'effectue au moyen d'un outil introduit dans un canal traversant le bloc terminal 70. Le jeu de barres d'alimentation de puissance 23, les broches 24 reliées à ces barres et des conducteurs intemes de contrôle 93 qui relient les broches 25 au circuit imprimé sont surmoulés dans la console 22 (voir figure 10). Un volet pivotant 94 apte à porter des étiquettes associées aux divers groupes d'appareils est monté à l'avant de la console 22 pour cacher les débouchés 95 des orifices d'accès aux bornes du disjoncteur 40 et/ou de son additif 45. Les bornes de contrôle mentionnées sont du type à serrage par vis ou par pièce élastique.

Le montage des sous-ensembles 30 sur le socle 20 du dispositif décrit est le suivant.

L'utilisateur commence par assembler le contacteur 60 au disjoncteur 40 par le bloc intermédiaire 50 en embrochant celui-ci d'un côté par les broches 52 dans les orifices 42a des bornes 42 du disjoncteur et de l'autre côté par les broches 53 et 57 dans les orifices 61a,65a des bornes 61,65 du contacteur et en serrant les vis des bornes. Puis il assemble le bloc terminal 70 au contacteur en introduisant ses broches 72 dans les orifices 66a des bornes 66 du contacteur et en serrant les vis de ces bornes. Pour monter le sous-ensemble ainsi réalisé sur le socle 20, l'utilisateur engage alors les talons 54,73 des blocs 50,70 en saillie à l'arrière du sous-ensemble dans les logements 26,27 du socle, puis fait glisser le sous-ensemble dans la direction Z le long de l'aire de support 21. Le glissement s'effectue avec guidage latéral par les parois 26b,27b des logements 26,27 jusqu'à l'accostage des cosses de puissance 24 dans les bornes 41 du disjoncteur et des broches de contrôle 25 dans les bornes 46 de son additif 45. Le verrou élastique 76 s'engage et assure le maintien du sous-ensemble contre tout déplacement intempestif dans la direction Z, tandis que les butées 26b,27b retiennent le sous-ensemble dans la direction X et que les épaulements 26c,27c l'empêchent d'être arraché du socle dans la direction Y. Le bloc 70 peut aussi être rapporté et connecté au socle après montage des appareils 40 et 60 avec leur bloc d'association 50.

En variante, le bloc intermédiaire 50 peut d'abord être assemblé au disjoncteur 40, puis le disjoncteur engagé selon la direction Z et connecté aux broches 24,25 ; le contacteur est ensuite engagé selon Z et connecté aux broches 53,57 du bloc 50 et le bloc 70 est monté et verrouille l'ensemble.

La connexion de puissance de l'ensemble à une source d'énergie est réalisée par le raccordement approprié de conducteurs au bornier frontal 23a. La connexion de contrôle est réalisée par le raccordement de câbles individuels ou en nappe au connecteur latéral 83.

Pour démonter un sous-ensemble, l'utilisateur desserre les vis des bornes 41 du disjoncteur correspondant, puis déverrouille le verrou 76 et saisit les formes 58 du bloc intermédiaire 50 et le dessous du bloc terminal 70, et tire le sous-ensemble vers le bas dans la direction opposée à Z1, ce mouvement étant limité par la butée du talon 54 contre le bas du logement 26, et enfin extrait le sous-ensemble du socle dans la direction X. Pour démonter seulement le contacteur d'un sous-ensemble, il suffit de desserrer les vis des bornes 61 du contacteur, puis de déverrouiller le verrou 76 et de poursuivre l'opération comme ci-dessus.

On constate qu'au montage le travail de câblage que doit effectuer l'utilisateur est considérablement simplifié, puisqu'il doit seulement raccorder initialement la charge aux bornes de puissance du contacteur, ainsi que l'alimentation triphasée de puissance et la source de tension de commande des contacteurs. L'adjonction d'un ensemble voisin s'effectue par emboîtement latéral des éléments mâles et femelles 91,92 et interconnexion des connecteurs de contrôle 83 et le cas échéant 84 mis en regard et des borniers de puissance adjacents 23a.

## Revendications

1. Ensemble d'appareils électriques affectés à la commande de puissance de charges, notamment ensemble de départ-moteur, comprenant un socle (20), pour chaque charge une paire d'appareils montée sur le socle et composée d'un disjoncteur (40) et d'un contacteur (60), ainsi qu'un jeu de conducteurs de puissance (23), les paires d'appareils étant juxtaposables sur le socle,
***caractérisé par le fait que** :*
- le socle (20) comporte une aire frontale de support (21) pour recevoir plusieurs paires d'appareils (30) et des broches de puissance (24) et de contrôle (25) coopérant avec des bornes respectives de puissance (41) et de contrôle (46) des paires d'appareils,
- l'un des appareils de chaque paire d'appareils (30) est engagé sur les broches de connexion de puissance (24) et de contrôle (25) du socle selon une direction d'engagement (Z) qui est sensiblement parallèle à l'aire de support (21).

2. Ensemble selon la revendication 1, **caractérisé par le fait qu'**à chaque paire d'appareils (30) est fixé au moins un bloc associé muni d'un organe d'emboîtement (54,73) coopérant avec un logement (26,27), ce logement étant doté de butées et d'épaulements de retenue (26a,27a) pour l'organe d'emboîtement et prévu sur ou dans le socle (20).

3. Ensemble selon la revendication 1, **caractérisé par le fait que** le socle (20) comporte une console (22) s'étendant à partir de l'aire de support (21) en avancée dans une direction (Y) perpendiculaire à l'aire pour loger le jeu de conducteurs de puissance (23), la console présentant des broches de connexion (24) pour coopérer avec les disjoncteurs des paires d'appareils.

4. Ensemble selon la revendication 3, **caractérisé par le fait que** la console (22) présente des conducteurs d'alimentation (23) surmoulés et des conducteurs internes de contrôle (93) surmoulés qui assurent la liaison entre les broches de connexion (24) et un circuit imprimé (80) logé dans le socle (20).

5. Ensemble selon la revendication 3, **caractérisé par le fait que** la console (22) présente un volet cache-bornes (94).

6. Ensemble selon la revendication 1, **caractérisé par le fait que** le socle (20) loge derrière l'aire de support (21) un circuit imprimé (80) muni, pour chaque paire d'appareils (30), de pistes d'interconnexion (85) de la bobine du contacteur (60) avec des conducteurs de contrôle (90) tels qu'un bus et de connecteurs (81,83) correspondants.

7. Ensemble selon la revendication 1, **caractérisé par le fait que** le contacteur (60) est associé au disjoncteur (40) au moyen d'un bloc intermédiaire (50) d'assemblage mécanique qui est doté d'un organe d'emboîtement (54) coopérant avec un logement (26) du socle et qui comprend d'une part des broches d'interconnexion de puissance (52,53) entre contacteur et disjoncteur, d'autre part des éléments de connexion de contrôle (56) coopérant avec des éléments de connexion complémentaires (81) prévus sur le socle.

8. Ensemble selon la revendication 1, **caractérisé par le fait qu'**un bloc terminal (70) est fixé sous le contacteur (60), est doté d'un organe d'emboîtement (73) coopérant avec un logement (27) du socle et comprend des broches (72) d'interconnexion avec des bornes de contrôle (66) du contacteur.

9. Ensemble selon la revendication 1, **caractérisé par le fait qu'**un verrou (76) est rapporté à un bloc intermédiaire (50) ou un bloc terminal (70) associé à la paire d'appareils (30) pour empêcher celle-ci de se déplacer à l'opposé de sa direction d'engagement (Z).

## Patentansprüche

1. Elektrische Schaltgerätekombination für die Leistungssteuerung von Ladungen, insbesondere Motorstart-Geräte, mit einem Sockel (20), für jede Ladung ein Paar auf dem Sockel montierte Geräte und bestehend aus einem Schutzschalter (40) und einer Schaltschütz (60), sowie einem Satz Leistungsleiter (23), wobei die Gerätepaare auf dem Sockel anreihbar sind,
**dadurch gekennzeichnet, dass**:
- der Sockel (20) eine Supportfläche (21) zur Aufnahme von mehreren Gerätepaaren (30) und Leistungssteckerstifte (24) und Kontrollsteckerstifte (25) besitzt, die mit den jeweiligen Leistungsklemmen (41) und Kontrollklemmen (46) der Gerätepaare zusammenwirken.
- eines der Geräte jedes Gerätepaares (30) auf den Leistungssteckerstiften (24) und den Kontrollsteckerstiften (25) des Sockels gemäß einer Steckrichtung (Z) sitzt, die deutlich parallel zur Supportfläche (21) verläuft.

2. Kombination nach Patentanspruch 1, **dadurch gekennzeichnet, dass** an jedes Gerätepaar (30) mindestens ein dazugehörender Block befestigt ist, der ein Einsteckelement (54, 73) besitzt, das mit einer Fassung (26, 27) zusammenarbeitet, wobei diese Fassung mit Anschlägen und Rückhalteschultern (26a, 27a) für das Einsteckelement versehen und auf oder im Sockel (20) angebracht ist.

3. Kombination nach Patentanspruch 1, **dadurch gekennzeichnet, dass** der Sockel (20) eine Konsole (22) besitzt, die sich ab der Supportfläche (21) in Richtung (Y) im rechten Winkel zu ihr nach vorne erstreckt, um den Leistungsleiter-Satz (23) aufzunehmen. Die Konsole verfügt weiterhin über Verbindungssteckerstifte (24), um mit den Schutzschaltern der Gerätepaare zusammenzuwirken.

4. Kombination nach Patentanspruch 3, **dadurch gekennzeichnet, dass** die Konsole (22) gegossene Versorgungsleiter (23) und gegossene interne Kontrollleiter (93) besitzt, die die Verbindung zwischen den Verbindungssteckerstiften (24) und einer bedruckten Schaltung (80), die im Sockel (20) eingelassen ist, sicher stellen.

5. Kombination nach Patentanspruch 3, **dadurch gekennzeichnet, dass** die Konsole (22) einen Klemmen-Klappdeckel (94) besitzt.

6. Kombination nach Patentanspruch 1, **dadurch gekennzeichnet, dass** der Sockel (20) hinter der Supportfläche (21) eine bedruckte Schaltung (80) aufnimmt, die für jedes Gerätepaar (30) Pisten für den Schaltverbund (85) der Schaltschützspule (60) mit den Kontrollleitern (90), zum Beispiel einem entsprechenden Bus und Anschluss-Steckern (81, 83), besitzt.

7. Kombination nach Patentanspruch 1, **dadurch gekennzeichnet, dass** die Schaltschütz (60) mit einem Schutzschalter (40) in Verbindung steht mittels eines mechanisch montierten Zwischenblocks (50), der ein Einsteckelement (54) besitzt, das mit einer Sockelfassung (26) zusammenwirkt, und auf einer Seite die Anschluss-Stecker des Leistungsschaltverbundes (52, 53) zwischen Schaltschütz und Schutzschalter aufweist und auf der anderen Seite die Kontrollanschlusselemente (56), die mit den komplementären und im Sockel vorgesehenen Anschlusselementen (81) zusammenwirken.

8. Kombination nach Patentanspruch 1, **dadurch gekennzeichnet, dass** ein Abschlussblock (70) auf der Schaltschütz (60) befestigt ist und über ein Einsteckelement (73) verfügt, das mit einer Fassung (27) im Sockel zusammenwirkt, und Anschluss-Stecker (72) besitzt für den Schaltverbund mit den Kontrollklemmen (66) der Schaltschütz.

9. Kombination nach Patentanspruch 1, **dadurch gekennzeichnet, dass** eine Klinke (76) an einen Zwischenblock (50) oder einen Abschlussblock (70) angesetzt ist, der mit einem Gerätepaar (30) in Verbindung steht, um dessen Verschiebung in der entgegengesetzten Einsteckrichtung (Z) zu verhindern.

## Claims

1. An assembly of electrical equipment for the power control of loads, notably a motor starter assembly, comprising a baseplate (20), for each load a pair of devices mounted on the baseplate and made up of a circuit breaker (40) and a contactor (60), as well as a set of power conductors (23), the pairs of devices being capable of being placed side by side on the baseplate,
***characterised by** the fact that :*
- the baseplate (20) comprises a support area (21) to receive several pairs of devices (30) and power pins (24) and control pins (25) that co-operate with respective power terminals (41) and control terminals (46) for the pairs of devices,
- one of the devices of each pair of devices (30) is engaged on the power connecting pins (24) and the control (25) connecting pins of the baseplate along an engagement direction (Z) which is approximately parallel to the support area (21).

2. An assembly according to Claim 1, **characterised by** the fact that to each pair of devices (30) is fixed at least one associated unit equipped with a fitting device (54, 73) that co-operates with a housing (26, 27), this housing being provided with abutments and retaining shoulders (26a, 27a) for the fitting device and is provided on or in the baseplate (20).

3. An assembly according to the Claim 1, **characterised by** the fact that the baseplate (20) comprises a bracket (22) extending from the support area (21) overhanging in the direction (Y) perpendicular to the area in order to house the set of power conductors (23), the bracket having connection pins (24) to co-operate with the circuit breakers of the pairs of devices.

4. An assembly according to Claim 3, **characterised by** the fact that the bracket (22) has power supply conductors (23) moulded into it and internal control conductors (93) moulded into it which provide the link between the connection pins (24) and a printed circuit (80) housed in the baseplate (20).

5. An assembly according to Claim 3, **characterised by** the fact that the bracket (22) has a flap (94) to conceal the terminals.

6. An assembly according to Claim 1, **characterised by** the fact that the baseplate (20), behind the support area (21), houses a printed circuit (80) fitted with, for each pair of devices (30), interconnection tracks (85) from the coil of the contactor (60) with control conductors (90) such as a bus and corresponding connectors (81, 83).

7. An assembly according to Claim 1, **characterised by** the fact that the contactor (60) is linked to the circuit breaker (40) by means of an intermediate mechanical assembly unit (50) which is equipped with a fitting device (54) that co-operates with a housing (26) in the baseplate and which includes on the one hand interconnection power pins (52, 53) between contactor and circuit breaker and on the other hand control connection elements (56) that co-operate with complementary connection elements (81) provided on the baseplate.

8. An assembly according to Claim 1, **characterised by** the fact that an end unit (70) is fixed under the contactor (60) and is equipped with a fixing device (73) that co-operates with a housing (27) in the baseplate and includes pins (72) for interconnection with the control terminals (66) of the contactor.

9. An assembly according to Claim 1, **characterised by** the fact that a catch (76) is joined onto an intermediate unit (50) or an end unit (70) associated with the pair of devices (30) to prevent it from being displaced in the opposite direction to its engagement direction (Z).
